# EUROPÄISCHE PATENTSCHRIFT

(11) **EP 1 277 229 B1**
(45) Veröffentlichungstag und Bekanntmachung des Hinweises auf die Patenterteilung: **06.09.2006**
(21) Anmeldenummer: 01931633.0
(22) Anmeldetag: 20.04.2001
(51) Int. Cl.: H01L 21/02

(54) **VERFAHREN ZUR HERSTELLUNG EINES INTEGRIERTEN KONDENSATORS**
METHOD FOR PRODUCING AN INTEGRATED CAPACITOR
PROCEDE DE PRODUCTION D'UN CONDENSATEUR INTEGRE

(30) Priorität: 28.04.2000 US 560541
(43) Veröffentlichungstag der Anmeldung: 22.01.2003
(73) Patentinhaber: Infineon Technologies AG, 81669 München (DE)
(72) Erfinder: AUGUSTIN, Andreas, 85630 Grasbrunn (DE); KLEIN, Wolfgang, 85604 Zorneding (DE); BARTH, Hans-Joachim, 81245 München (DE)
(74) Vertreter: Barth, Stephan Manuel
(86) Internationale Anmeldenummer: PCT/EP2001/004525
(87) Internationale Veröffentlichungsnummer: WO 2001/084604

(56) Entgegenhaltungen:
- EP-A- 0 771 022
- WO-A-96/17386
- US-A- 5 808 855
- US-A- 5 965 942

## Beschreibung

Die Erfindung betrifft ein Verfahren zur Herstellung eines integrierten Kondensators mit optimierter Flächenausnutzung der Chipfläche, wobei das Verfahren modular in Standard-Herstellungsprozesse einfügbar ist.

In integrierten Schaltungen werden neben den üblichen aktiven elektronischen Bauelementen, wie beispielsweise Transistoren oder Dioden, auch passive Bauelemente wie Kondensatoren benötigt. Um die für die passiven Bauelemente erforderliche Chipfläche zu minimieren, müssen die integrierten Kondensatoren mit einer sehr hohen spezifischen Flächenkapazität hergestellt werden. Damit die Herstellung der integrierten Kondensatoren den Gesamtherstellungsprozess der integrierten Schaltung nicht verkomplizieren und somit die Herstellungskosten steigern, muss ein Verfahren zur Herstellung eines integrierten Kondensators modular in die Standard-Prozessabläufe zur Herstellung der integrierten Schaltung einfügbar sein.

WO-A-9617386 offenbart ein Verfahren zur Herstellung eines Kondensators mit einer Kontaktstruktur.

Es ist die Aufgabe der vorliegenden Erfindung, ein Verfahren zur Herstellung eines integrierten Kondensators zu schaffen, das modular in die bisherigen Herstellungsprozessabläufe zur Herstellung einer integrierten Schaltung einfügbar ist und einen Kondensator mit einer hohen spezifischen Flächenkapazität schafft.

Diese Aufgabe wird erfindungsgemäß durch ein Verfahren mit den im Patentanspruch 1 angegebenen Merkmalen gelöst.

Besondere Ausführungsformen sind in den Unteransprüchen aufgeführt. Die Erfindung bietet den besonderen Vorteil, dass das Hindurchätzen durch die dielektrische Schicht nur einmal zur Ausbildung der integrierten Kondensatoren und der Durchkontaktierungsöffnungen erfolgen muss und so der Herstellungsaufwand verringert wird.

Bei einer weiteren vorteilhaften Ausgestaltung des erfindungsgemäßen Verfahrens werden als dünne dielektrische Schichten eine Schicht aus Siliciumdioxid, Tantalpentoxid, Aluminiumoxid, Titandioxid oder Siliciumnitrid abgeschieden.

Bei einer weiteren vorteilhaften Ausgestaltung bestehen die ausgebildeten Metallisierungsschichten aus Aluminium, Aluminiumlegierungen, Kupfer oder Kupferlegierungen.

Bei einer ersten Ausführungsform werden als leitfähige Schichten Diffusionsbarrierematerialien abgeschieden.

Die Diffusionsbarrierematerialien umfassen vorzugsweise Titan, Titannitrid, Tantal oder Tantalnitrid Wolframnitrid oder ternäre Verbindungen wie beispielsweise TiSiN oder TaSiN.

Bei einer weiteren Ausführungsform werden als leitfähige Schichten Leitermaterialien wie Wolfram, Aluminium oder Kupfer abgeschieden.

Die beiden strukturierten Metallschichten werden vorzugsweise in einem Damascene-Prozeß als Metallgräben ausgebildet.

Bei einer alternativen Ausführungsform werden die beiden strukturierten Metallschichten durch Ätzen einer aufgebrachten Metallschicht ausgebildet.

Nach dem Ausbilden der strukturierten zweiten Metallschicht ist die Ätzöffnung vorzugsweise planar aufgefüllt.

Bei einer Ausführungsform des Verfahrens werden diejenigen Teile der abgeschiedenen leitfähigen Schichten und der abgeschiedenen dielektrischen Schicht, die über die gebildete Ätzöffnung hinausragen, nach dem Ausbilden der zweiten Metallschicht entfernt.

Die hinausragenden Teile der abgeschiedenen Schichten werden vorzugsweise durch chemisch-mechanisches Polieren oder durch strukturiertes Ätzen entfernt.

Bei dem Entfernen der hinausragenden Teile der abgeschiedenen Schichten durch strukturiertes Ätzen bildet die dicke dielektrische Schicht vorzugsweise die Ätz-Stoppschicht.

Bei einer bevorzugten Ausführungsform wird die Trägerschicht, auf der die erste strukturierte Metallschicht ausgebildet wird, durch eine dicke zwischenoxidschicht gebildet.

Dies bietet den besonderen Vorteil, dass die parasitäre Substratverkopplung des gebildeten integrierten Kondensators zu dem Substrat der integrierten Schaltung sehr gering ist.

Bei einer bevorzugten Ausführungsform des erfindungsgemäßen Verfahrens ist die durch das Hindurchätzen gebildete Seitenwandfläche der Ätzöffnung weitaus großflächiger als die freigelegte Grundfläche.

Dies bietet den besonderen Vorteil, dass der integrierte Kondensator auf einer sehr kleinen Chipfläche bei gleichzeitig hoher Kapazität ausgebildet werden kann.

Im weiteren werden bevorzugte Ausführungsformen des erfindungsgemäßen Verfahrens unter Bezugnahme auf die beigefügten Zeichnungen beschrieben.

Es zeigen:
Fig. 1a, 1b die Ausbildung eines integrierten Kondensators gemäß einer ersten Ausführungsform des erfindungsgemäßen Verfahrens;
Fig. 2a, 2b, 2c die Ausbildung eines integrierten Kondensators gemäß einer zweiten Ausführungsform des erfindungsgemä-ßen Verfahrens;
Fig. 3a, 3b, 3c die Ausbildung eines integrierten Kondensators gemäß einer dritten Ausführungsform des erfindungsgemä-ßen Verfahrens.

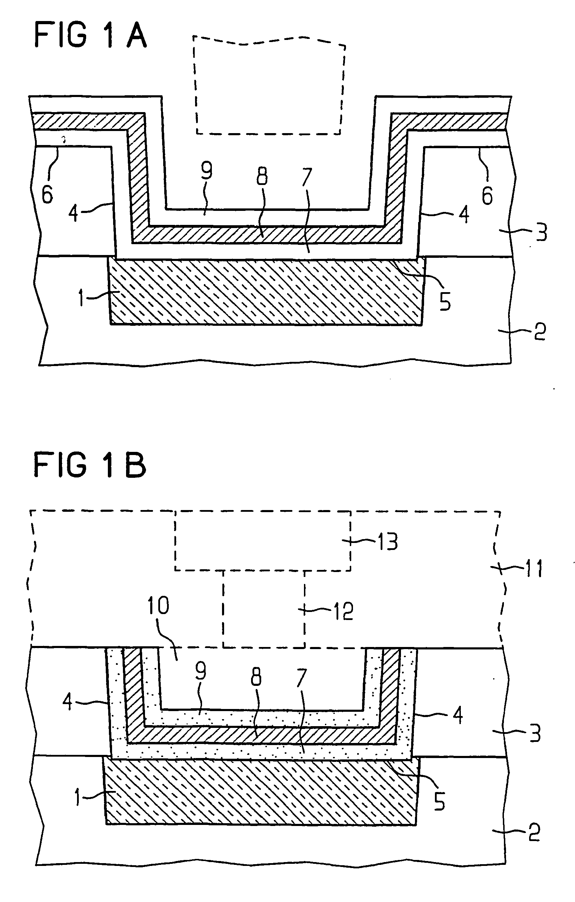

Die Fig. 1a, 1b zeigen schematisch, wie ein integrierter Kondensator gemäß einer ersten Ausführungsform des erfindungsgemäßen Verfahrens gebildet wird.

Zunächst wird in einem Damascene-Standardprozeß eine strukturierte erste Metallschicht 1 auf einer Trägerschicht 2 ausgebildet. Die strukturierte erste Metallschicht 1 ist dabei als ein Metallgraben in der Trägerschicht 2 ausgebildet. Die Trägerschicht 2 und die darin eingebettete strukturierte Metallschicht 1 werden ganzflächig mit einer dicken dielektrischen Schicht 3 überzogen. Die dicke dielektrische Schicht wird beispielsweise aus Siliciumdioxid gebildet. Es können aber auch andere dielektrische Materialien, insbesondere Materialien mit niedriger Dielektrizitätskonstante, verwendet werden. Die dielektrische Schicht 3 wird mit einer Photomaske überzogen und lokal geätzt. Danach wird der aufgebrachte Photolack entfernt. Beim lokalen Hindurchätzen durch die dicke dielektrische Schicht 3 bis hin zu der strukturierten ersten Metallschicht 1 wird eine kraterförmige Ätzöffnung ausgebildet. Diese Ätzöffnung weist Seitenwandflächen 4, die durch die Oberfläche der dielektrischen Schicht 3 gebildet wird, sowie eine Grundfläche 5 auf, die durch die freigelegte Oberfläche der strukturierten ersten Metallschicht 1 gebildet wird. Da die erste dielektrische Schicht 3 relativ dick ist, ist die durch das Hindurchätzen gebildete Seitenwandfläche 4 weitaus großflächiger als die freigelegte Grundfläche 5. Die Dicke der dielektrischen Schicht 3 beträgt typischerweise etwa 0,5 µm -2,0 µm, während der Durchmesser der beiliegenden Grundfläche 5 zwischen 0,4µm und 100 µm liegen kann. Auf der freiliegenden Grundfläche 5 der Seitenwandfläche 4 der dielektrischen Schicht 3 sowie auf der Oberfläche 6 der dielektrischen Schicht 3 wird eine erste leitfähige Schicht 7 abgeschieden. Auf dieser ersten leitfähigen Schicht 7 wird danach eine dünne dielektrische Schicht 8 abgeschieden. Die dünne dielektrische Schicht 8 besteht vorzugsweise aus Siliciumdioxid, Tantalpentoxid, Aluminiumoxid, Titandioxid oder Siliciumnitrid. Die dünne dielektrische Schicht 8 kann aus demselben dielektrischen Material hergestellt werden wie die dicke dielektrische Schicht 3. Vorzugsweise weist die dünne dielektrische Schicht 8 eine hohe Dielektrizitätskonstante auf, damit die spezifische Flächenkapazität hoch ist. Die dünne dielektrische Schicht 8 hat dabei eine möglichst geringe Dicke, bei der jedoch Tunnelstromeffekte vermieden werden.

Auf der dünnen dielektrischen Schicht 8 wird eine zweite leitfähige Schicht 9 abgeschieden. Die zweite leitfähige Schicht 9 kann aus demselben Material hergestellt sein wie die erste leitfähige Schicht 7. Die beiden leitfähigen Schichten 7, 9 bestehen bei einer ersten Ausführungsform aus Diffusionsbarrierematerialien, wie Titan, Titannitrid, Tantal oder Tantalnitrid. Auch sonstige Diffusionsbarrierematerialien können eingesetzt werden.

Bei einer alternativen Ausführungsform bestehen die leitfähigen Schichten 7, 9 aus Leitermaterialien, wie Wolfram, Aluminium oder Kupfer.

Besteht die zweite leitfähige Schicht 9 aus einem oxidationsempfindlichen Material, wie beispielsweise Kupfer, wird die zweite leitfähige Schicht vorzugsweise durch eine (in der Fig. 1a nicht dargestellte) zusätzliche Schutzisolatorschicht abgedeckt. Die Schutzisolatorschicht besteht beispielsweise aus Siliciumdioxid, Siliciumnitrid und dergleichen.

Diejenigen Teile der abgeschiedenen leitfähigen Schichten 7, 9 und der abgeschiedenen dünnen dielektrischen Schicht 8, die über die Ätzöffnung hinausragen, werden anschließend entfernt. Das Entfernen kann entweder durch chemisch-mechanisches Polieren CMP oder durch strukturiertes Ätzen oder durch eine Kombination von Ätzen und Polieren erfolgen. Nach dem Entfernen der abgeschiedenen Schichten 7, 8, 9 darf zwischen der ersten leitfähigen Schicht 7 und der zweiten leitfähigen Schicht 9 kein elektrischer Kontakt bestehen. Erfolgt das Entfernen der leitfähigen Schichten 7, 8, 9, die über die Ätzöffnung hinausragen, durch Ätzen, kann die dicke dielektrische Schicht 3 als Ätz-Stoppschicht dienen.

Fig. 1 b zeigt die Herstellungsstufe nach dem Entfernen der über die Ätzöffnung hinausragenden abgeschiedenen Schichten 7, 8, 9. Die beiden leitfähigen Schichten 7, 9 sowie die dielektrische Schicht 8 zwischen den beiden leitfähigen Schichten 7, 9 bilden eine Wanne innerhalb der Ätzöffnung in der dicken dielektrischen Schicht 3. In diese Wanne wird vorzugsweise eine zweite strukturierte Metallschicht ausgebildet. Alternativ dazu kann die Wanne auch mit Material aufgefüllt werden, die identisch mit dem Material der zweiten leitfähigen Schicht 9 ist. Die derart aufgefüllte Wanne 10 bildet zusammen mit der grabenförmigen Metallschicht 1 die beiden Elektroden des hergestellten Kondensators.

Die aufgefüllte elektrisch leitfähige Wanne 10 sowie die erste dicke dielektrische Schicht 3 können zusätzlich wiederum mit einer weiteren dielektrischen Schicht 11 überzogen werden, in der herkömmlicherweise eine Durchkontaktierungsöffnung 12 und eine Anschlußwanne 13 gebildet wird. Die Durchkontaktierungsöffnung 12 wird dabei vorzugsweise durch Wolfram Aluminium oder Kupfer gefüllt, wobei die obere Metallaufnahmewanne 13 zur Bildung der oberen Elektrode des Kondensators mit einem beliebigen leitfähigen Material, beispielsweise Aluminium, gefüllt werden kann.

Die in Fig. 1b gezeigte Trägerschicht besteht vorzugsweise aus einem sehr dicken Zwischenoxid, so dass der Abstand des ausgebildeten Kondensators zu dem Substrat hoch ist und somit die parasitäre Substratverkopplung minimiert wird.

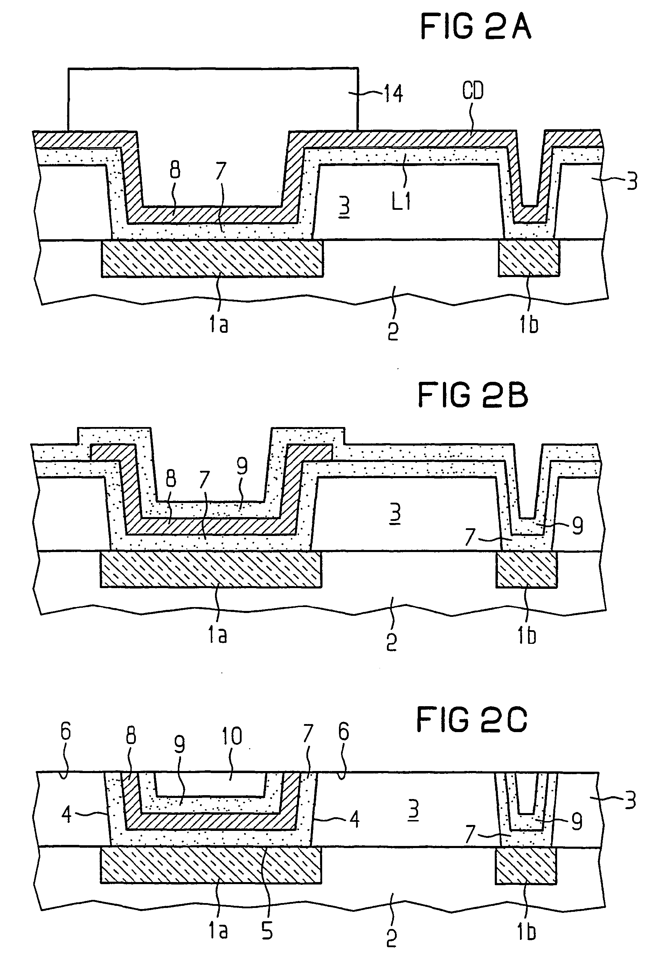

Fig. 2a, 2b, 2c zeigen die Ausbildung eines integrierten Kondensators gemäß einer zweiten Ausführungsform des erfindungsgemäßen Herstellungsverfahrens.

Bei dieser Ausführungsform wird wiederum eine erste strukturierte Metallschicht 1 auf einer Trägerschicht 2 ausgebildet. Man erkennt in Fig. 2a einen ersten eingebetteten Metallgraben 1a und einen zweiten eingebetteten Metallgraben 1b. Der erste Metallgraben 1a bildet dabei später eine Elektrode des zu bildenden integrierten Kondensators, während der Metallgraben 1b Teil einer Durchkontaktierung bildet. Die beiden Metallgräben 1a, 1b werden wiederum in einem Standard-Damascene-Prozeß hergestellt. Die strukturierten Metallschichten 1a, 1b werden mit der dicken dielektrischen Schicht 3 überzogen, die wiederum nach Anwendung einer Standard-Phototechnik geätzt wird. Wie man aus Fig. 2a erkennen kann, erfolgt das lokale Hindurchätzen durch die dicke dielektrische Schicht 3 zur Ausbildung des integrierten Kondensators gleichzeitig mit dem Hindurchätzen durch die dielektrische Schicht 3 der Ausbildung der Durchkontaktierung. Nach dem Ätzen wird der Photolack entfernt und die erste leitfähige Schicht 7 abgeschieden. Danach erfolgt das Abscheiden der dünnen dielektrischen Schicht 8. Zur Ausbildung des späteren integrierten Kondensators wird die dünne dielektrische Schicht im Bereich der Ätzöffnung für den Kondensator mit Photolack 14 überzogen, wie man aus Fig. 2a ersehen kann.

Anschließend erfolgt eine isotrope Ätzung der dünnen dielektrischen Schicht 8 selektiv zu der ersten leitfähigen Schicht 7. Der Ätzvorgang kann mittels Naß- oder Trockenätzung durchgeführt werden. Danach wird der Photolack 14 entfernt und die zweite leitfähige Schicht 9 aufgebracht. Das Ergebnis dieses Vorgangs ist in Fig. 2b dargestellt. Die Durchkontaktierungsöffnung sowie die im Kondensatorbereich gebildete Wanne werden anschließend planar mit einem Metall oder einer Metallegierung aufgefüllt. Anschließend wird in einem chemisch-mechanischen Polierschritt die gebildete Struktur geschliffen. Dabei wird die in Fig. 2c hergestellte Struktur erzeugt. Die weitere Kontaktierung des Kondensators kann analog zu der in Fig. 1b gezeigten Ausführungsform durchgeführt werden.

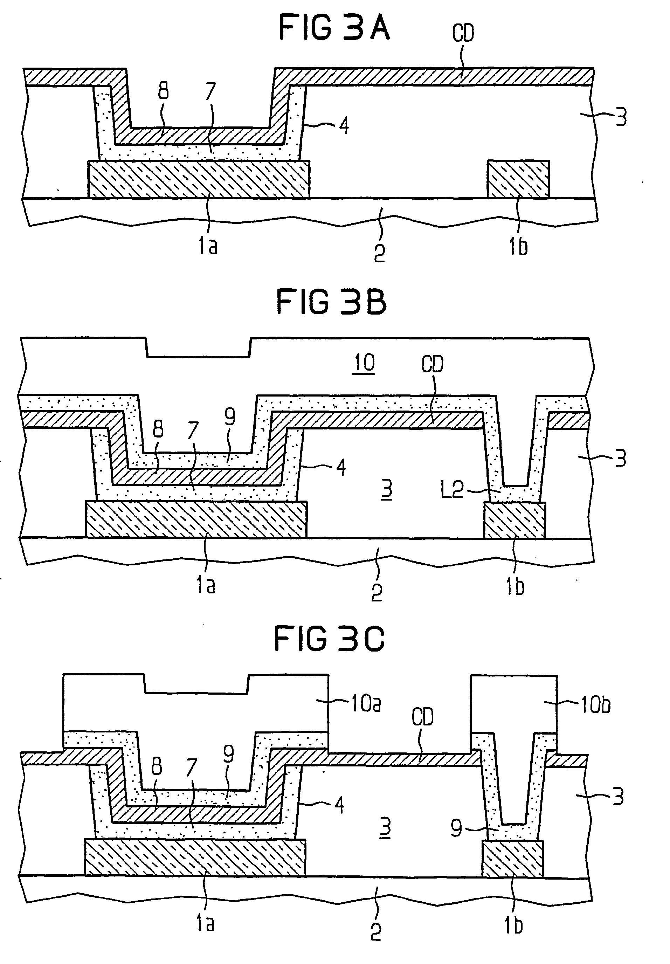

Die Fig. 3a, 3b, 3c dienen der Erläuterung einer dritten Variante des erfindungsgemäßen Herstellungsverfahrens. Hierbei wird die strukturierte erste Metallschicht 1 nicht wie bei den ersten beiden Ausführungsformen durch einen Standard-Damascene-Prozess als eingebettete Metallgräben ausgebildet, sondern in einem Ätzprozess aus einer auf der Trägerschicht 2 abgeschiedenen Metallschicht gebildet. Man erkennt in Fig. 3a eine erste Metallschichtstruktur 1a zur Ausbildung des späteren Kondensators und eine zweite Metallschichtstruktur 1b zur Ausbildung einer Durchkontaktierung. Die strukturierte erste Metallschicht 1 wird wiederum mit einer dicken dielektrischen Schicht 3 überzogen, in die mittels einer Photomaskierung eine Ätzöffnung für den späteren Kondensator geätzt wird, bis die Oberfläche der ersten Metallschichtstruktur 1a freiliegt. Anschließend wird eine erste leitfähige Schicht über die gesamte Oberfläche abgeschieden und in einem chemisch-mechanischen Polierschritt die abgeschiedene erste leitfähige Schicht so weit entfernt, dass sie nur mehr in der gebildeten Ätzwanne des Kondensators verbleibt. Danach wird über die gesamte Fläche die dünne dielektrische Schicht 8 abgeschieden. Die Fig. 3a zeigt den Herstellungsvorgang, nachdem die dünne dielektrische Schicht 8 abgeschieden worden ist.

Anschließend wird mittels Standard-Phototechnik und durch Ätzen eine Ätzöffnung für die spätere Durchkontaktierung zu der Metallstruktur 1b geschaffen. Der Photolack wird dann entfernt und über die gesamte Oberfläche eine zweite leitfähige Schicht 9 abgeschieden. Anschließend wird auf der Gesamtstruktur eine zweite Metallschicht 10 abgeschieden, wie man aus Fig. 3b erkennen kann. Diese Metallschicht 10 wird dann in weiteren Prozessschritten, nämlich einer Photomaskierung, einem Ätzvorgang sowie einer Photolackentfernung strukturiert, so dass die in Fig. 3c dargestellte Metallschichtstruktur 10a, 10b entsteht. Bei dieser Ausführungsform kann die durch die zweite leitfähige Schicht 9 gebildete Kondensatorplatte direkt über die zweite strukturierte Metallschicht angeschlossen werden.

Bei dem erfindungsgemäßen Herstellungsverfahren werden die Metallschichten bei der Metallisierung einer integrierten Schaltung zur zusätzlichen Herstellung von Kondensator-Bauelementen ausgenützt. Dabei können die Herstellungsschritte des erfindungsgemäßen Herstellungsverfahrens modular in die bisher bekannten Prozessschritte des Standardprozesses zur Herstellung integrierter Schaltungen modular eingefügt werden. Durch Ausnutzung der großflächigen Seitenwandungen der gebildeten Ätzöffnungen weisen die derart gebildeten Kondensatoren eine hohe Kapazität auf, wobei sie gleichzeitig nur eine sehr geringe Chipfläche beanspruchen. Durch den hohen Abstand zu dem Substrat wird darüber hinaus die parasitäre Substratverkopplung des gebildeten integrierten Kondensators minimiert. Die Integration des Kondensators kann vollständig modular und ohne Beeinflussung der übrigen gebildeten Bauelemente der integrierten Schaltung durchgeführt werden.

### Bezugszeichenliste

- 1: erste strukturierte Metallschicht
- 2: Trägerschicht
- 3: dicke dielektrische Schicht
- 4: Seitenwandfläche
- 5: Grundfläche
- 6: Oberfläche der dicken dielektrischen Schicht
- 7: erste leitfähige Schicht
- 8: dünne dielektrische Schicht
- 9: zweite leitfähige Schicht
- 10: zweite strukturierte Metallschicht
- 11: dicke dielektrische
- 12: Durchkontaktier
- 13: Metallaufnahmewann
- 14: Photolack

## Patentansprüche

1. Verfahren zur gleichzeitigen Herstellung eines integrierten Kondensators und eines Kontaktes mit den folgenden Schritten:
(a) Ausbilden einer strukturierten ersten Metallschicht (1a, 1b) auf oder in einer Trägerschicht (2);
(b) Überziehen der strukturierten ersten Metallschicht (1a, 1b) und der Trägerschicht (2) mit einer dicken dielektrischen Schicht (3);
(c) lokales Hindurchätzen durch die dicke dielektrische Schicht bis hin zu einem ersten und einem zweiten Bereich (1a, 1b) der strukturierten ersten Metallschicht (1) zum Ausbilden einer ersten und zweiten Ätzöffnung mit einer jeweiligen Seitenwandfläche (4) und Grundfläche,
wobei die Grundfläche durch die freigelegten Oberflächen des ersten und zweiten Bereichs (1a, 1b) der strukturierten ersten Metallschicht (1) gebildet werden;
(d) Abscheiden einer ersten leitfähigen Schicht (7) auf den gebildeten Grundflächen (5), Seitenwandflächen und der dicken dielektrischen Schicht (3);
(e) Abscheiden einer dünnen dielektrischen Schicht (8) auf der ersten leitfähigen Schicht (7);
(f) Bilden einer Maske (14) auf der dünnen dielektrischen Schicht (8) im Bereich der ersten Ätzöffnung;
(g) selektives Ätzen der dünnen dielektrischen Schicht (8) bezüglich der ersten leitfähigen Schicht (7) zum Entfernen der dünnen dielektrischen Schicht (8) aus der zweiten Ätzöffnung;
(h) Entfernen der Maske (14);
(i) Abscheiden einer zweiten leitfähigen Schicht (9) auf der dünnen dielektrischen Schicht (8) und der im Bereich der ersten Ätzöffnung verbleibenden ersten leitfähigen Schicht (7);
(j) Auffüllen der ersten und zweiten Ätzöffnung mit einer zweiten Metallschicht (10);
(k) Planarisieren der resultierenden Struktur zum Entfernen der ersten, zweiten und leitfähigen Schicht (7, 9), der zweiten Metallschicht (10) und der dünnen dielektrischen Schicht (8) ausserhalb der ersten und zweiten Ätzöffnung, so dass der Kondensator in der ersten Ätzöffnung und der Kontakt in der zweiten Ätzöffnung gebildet wird.

2. Verfahren nach Anspruch 1,
**dadurch gekennzeichnet,**
**dass** als die dünne dielektrische Schicht (8) eine Schicht aus Siliziumdioxid, Tantalpentoxid, Aluminiumoxid, Titandioxid oder Siliziumnitrid abgeschieden wird.

3. Verfahren nach einem der vorangehenden Ansprüche,
**dadurch gekennzeichnet,**
**dass** die erste und zweite Metallschicht (1a, 1b; 10) aus Aluminium, Aluminiumlegierungen, Kupfer oder Kupferlegierungen bestehen.

4. Verfahren nach einem der vorangehenden Ansprüche,
**dadurch gekennzeichnet,**
**dass** die erste und zweite leitfähige Schicht (7, 9) aus Diffusionsbarrierematerialien bestehen.

5. Verfahren nach Anspruch 4,
**dadurch gekennzeichnet,**
**dass** die Diffusionsbarrierematerialien Titan, Titannitrid, Tantal, Tantalnitrid, Wolframnitrid oder ternäre Verbindungen insbesondere TiSiN und TaSiN umfassen.

6. Verfahren nach einem der vorangehenden Ansprüche 1 bis 4,
**dadurch gekennzeichnet,**
**dass** als erste und zweite leitfähige Schicht (7, 9) Schichten aus Wolfram, Aluminium oder Kupfer abgeschieden werden.

7. Verfahren nach einem der vorangehenden Ansprüche,
**dadurch gekennzeichnet,**
**dass** die Trägerschicht (2) durch ein dickes Zwischenoxid gebildet wird.

## Claims

1. Method for the simultaneous production of an integrated capacitor and a contact comprising the following steps:
(a) formation of a structured first metal layer (1a, 1b) on or in a base layer (2);
(b) covering the structured first metal layer (1a, 1b) and the base layer (2) with a thick dielectric layer (3);
(c) local etching through the thick dielectric layer as far as a first and a second region (1a, 1b) of the structured first metal layer (1) in order to form a first and second etched opening having a respective side wall surface (4) and a bottom surface (5),
the bottom surface being formed by the exposed surfaces of the first and second region (1a, 1b) of the structured first metal layer (1);
(d) deposition of a first conductive layer (7) on the bottom surfaces (5) that are formed, side wall surfaces and on the thick dielectric layer (3);
(e) deposition of a thin dielectric layer (8) on the first conductive layer (7);
(f) formation of a mask (14) on the thin dielectric layer (8) in the area of the first etching opening;
(g) selected etching of the thin dielectric layer (8) with respect to the first conductive layer (7) in order to remove the thin dielectric layer (8) from the second etching opening;
(h) removal of the mask (14);
(i) deposition of a second conductive layer (9) on the thin dielectric layer (8) and on the first conductive layer (7) which remains in the area of the first etching opening;
(j) filling of the first and second etching openings with a second metal layer (10);
(k) planarization of the resultant structure in order to remove the first, the second and the conductive layer (7, 9), the second metal layer (10) and the thin dielectric layer (8) outside the first and second etching openings, so that the capacitor is formed in the first etching opening, and the contact is formed in the second etching opening.

2. Method according to Claim 1,
**characterized**
**in that** a layer composed of silicon dioxide, tantalum pentoxide, aluminium oxide, titanium dioxide or silicon nitride is deposited as the thin dielectric layer (8).

3. Method according to one of the preceding claims,
**characterized**
**in that** the first and second metal layers (1a, 1b; 10) are composed of aluminium, aluminium alloys, copper or copper alloys.

4. Method according to one of the preceding claims,
**characterized**
**in that** the first and second conductive layers (7, 9) are composed of diffusion-barrier materials.

5. Method according to Claim 4,
**characterized**
**in that** the diffusion barrier materials comprise titanium, titanium nitride, tantalum, tantalum nitride, tungsten nitride or ternary compounds in particular TiSiN and TaSiN.

6. Method according to one of the preceding Claims 1 to 4,
**characterized**
**in that** layers composed of tungsten, aluminium or copper are deposited as the first and second conductive layer (7, 9).

7. Method according to one of the preceding claims,
**characterized**
**in that** the base layer (2) is formed by a thick intermediate oxide.

## Revendications

1. Procédé de fabrication simultanée d'un condensateur intégré et d'un contact avec les étapes suivante:
(a) Production d'une première couche métallique structurée (1a, 1b) sur ou dans une couche support (2) ;
(b) Revêtement de la première couche métallique structurée (1a, 1b) et de la couche support (2) par une épaisse couche diélectrique (3) ;
(c) Corrosion localisée au travers de l'épaisse couche diélectrique jusqu'à une première et une deuxième région (1a, 1b) de la première couche métallique structurée (1) destinée à la production d'une première et d'une deuxième ouverture de corrosion avec respectivement une surface latérale (4) et une surface de base,
la surface de base étant formée par les surfaces dégagées de la première et de la deuxième région (1a, 1b) de la première couche métallique structurée (1) ;
(d) Précipitation d'une première couche conductrice (7) sur les surfaces de base (5), sur les surfaces latérales et sur la surface diélectrique épaisse (3) formées ;
(e) Précipitation d'une fine couche diélectrique (8) sur la première couche conductrice (7) ;
(f) Formation d'un masque (14) sur la fine couche diélectrique (8) dans la région de la première ouverture de corrosion ;
(g) Corrosion sélective de la fine couche diélectrique (8) par rapport à la première couche conductrice (7) destinée à l'élimination la fine couche diélectrique (8) de la deuxième ouverture de corrosion ;
(h) Elimination du masque (14) ;
(i) Précipitation d'une deuxième couche conductrice (9) sur la fine couche diélectrique (8) et sur la première couche conductrice (7) restante dans la région de la première ouverture de corrosion ;
(j) Remplissage de la première et de la deuxième ouverture de corrosion avec une deuxième couche métallique (10) ;
(k) Aplatissement de la structure résultante pour éliminer la première couche diélectrique, la deuxième couche diélectrique et la couche conductrice (7, 9), la deuxième couche métallique (10) et la fine couche diélectrique (8) hors de la première et de la deuxième ouverture de corrosion, de sorte que le condensateur se forme dans la première ouverture de corrosion et le contact dans la deuxième ouverture de corrosion.

2. Procédé selon la revendication 1
**caractérisé**
**en ce que** comme couche fine diélectrique (8) est précipitée une couche de dioxyde de silicium, de pentoxyde de tantale, d'oxyde d'aluminium, de dioxyde de titane ou de nitrure de silicium.

3. Procédé selon l'une quelconque des revendications précédentes
**caractérisé**
**en ce que** la première couche métallique et la deuxième couche métallique (1a, 1b, 10) se composent d'aluminium, d'alliages d'aluminium, de cuivre ou d'alliages de cuivre.

4. Procédé selon l'une quelconque des revendications précédentes
**caractérisé**
**en ce que** la première couche métallique et la deuxième couche conductrices (7, 9) se composent de matériaux barrières de diffusion.

5. Procédé selon la revendication 4
**caractérisé**
**en ce que** les matériaux barrières de diffusion comportent du titane, du nitrure de titane, du tantale, du nitrure de tantale, du nitrure de tungstène ou des composés ternaires, en particulier TiSiN et TaSiN.

6. Procédé selon l'une quelconque des revendications précédentes 1 à 4
**caractérisé**
**en ce que** comme première et deuxième couche conductrices (7, 9) sont précipitées des couches de tungstène, d'aluminium ou de cuivre.

7. Procédé selon l'une quelconque des revendications précédentes
**caractérisé**
**en ce que** la couche support (2) est formée par une un oxyde intermédiaire épais.
